# EUROPÄISCHE PATENTSCHRIFT

(11) **EP 1 022 934 B1**
(45) Veröffentlichungstag und Bekanntmachung des Hinweises auf die Patenterteilung: **22.03.2006**
(21) Anmeldenummer: 00100303.7
(22) Anmeldetag: 07.01.2000
(51) Int. Cl.: H05K 7/14

(54) **Busleiterabschnitt für ein elektrisches Gerät**
Bus section for an electrical apparatus
Tronçon de bus pour appareil électrique

(30) Priorität: 25.01.1999 DE 29901194 U
(43) Veröffentlichungstag der Anmeldung: 26.07.2000
(73) Patentinhaber: Weidmüller Interface GmbH & Co., 32760 Detmold (DE)
(72) Erfinder: Zebermann, Christoph, 37688 Beverungen (DE); Schnatwinkel, Michael, 32051 Herford (DE)
(74) Vertreter: Specht, Peter

(56) Entgegenhaltungen:
- DE-A- 19 610 559
- DE-C- 4 438 801
- DE-U- 29 713 960
- US-A- 4 401 351

## Beschreibung

Die Neuerung betrifft einen Busleiterabschnitt für ein elektrisches Gerät mit modularem Aufbau zur Steuerung und/oder Überwachung technischer Prozesse und/oder zur Industrie- und/oder Gebäudeautomatisierung, mit wenigstens einem auf eine Tragschiene aufsetzbaren Anschlußmodul für externe Leiter und mit einer Reihung scheibenförmiger Basis-Klemmenträger, wobei innerhalb jedes Anschlußmodules der interne Busleiterabschnitt im wesentlichen parallel zur Tragschiene verläuft.

Ein gattungsgemäßer Busleiterabschnitt für ein elektrisches Gerät ist aus der EP 0 709 932 A2 bekannt. Bei dem in dieser Schrift gezeigten Gerät, bei dem der interne Busleiterabschnitt als durchgehende Platine mit darauf aufgebrachten Leiterbahnen ausgebildet ist, dienen auf Tragschienen anreihbare Anschlußblocks zur Signalanpassung zwischen einem übergeordneten Feldbus und an die Anschlußblocks angeschlossenen Initiatoren, Feldgeräten oder dergleichen. Die Anschlußblocks sind aus funktionsverschiedenen Anschluß- bzw. Modulscheiben zusammengesetzt, wobei zwischen Schutzleiterscheiben, Einspeisescheiben, Versorgungs-/Signalleiterscheiben und Rastfußscheiben unterschieden wird. Ein oder mehrere Anschlußblocks sind über den internen Busleiter mit einem Anschlußmodul für den Feldbus verbindbar.

Der interne Busleiterabschnitt dieser Lösung bringt das Problem mit sich, daß hinsichtlich einer beliebig langen Reihung von Modulscheiben und Modulblöcken verschiedenen Typs innerhalb des Anschlußmodules keine genügende Variabilität gegeben ist. Die Neuerung zielt darauf ab, dieses Problem auf konstruktiv und baulich einfache Weise platzsparend zu lösen.

Die Neuerung erreicht dieses Ziel durch den Gegenstand des Anspruches 1. Dabei sind die Busleiterabschnitte der einzelnen Basis-Klemmenträger baulich voneinander getrennt ausgebildet und weisen jeweils eine Platine auf, die von wenigstens einer Reihe von Metallstiften durchsetzt ist, welche auf der einen Seite der Platine im wesentlichen senkrecht und auf der gegenüberliegenden Seite der Platine im wesentlichen parallel zur Platine ausgerichtet sind, wobei die wenigstens eine senkrecht zur Platine erstreckende Stiftreihe derart bemessen ist, daß ihre Stiftreihenenden direkt zum Kontaktieren einer Buchsenleiste nutzbar sind.

Die bauliche Trennung der Busleiterabschnitte jeder Modulscheibe bringt zunächst den Vorteil einer nahezu beliebigen Reihbarkeit auch der Busleiterabschnitte mit sich und erhöht derart die Variabilität des gesamten Modulsystemes. Darüberhinaus bringt die gewählte bauliche Ausgestaltung des Busleiterabschnitts mit einer Platine und die Platine durchdringenden Winkelstiften besonderer Länge den Vorteil mit sich, daß separate Steckerelemente zum Kontaktieren eines separaten oder eines an eine Elektronik-Leiterplatte angeformten Gerätesteckers entfallen können.

Alternativ ist es auch denkbar, daß die Busleiterabschnitte der einzelnen Basis-Klemmenträger jeweils eine Platine aufweisen, auf die wenigstens eine Reihe der abgewinkelten Metallstifte aufgesetzt ist, welche mit einem ihrer Enden im wesentlichen senkrecht und mit ihren anderen Enden im wesentlichen parallel zur Platine liegen, wobei wiederum die senkrecht zur Platine stehenden Stiftreihenenden derart bemessen sind, daß sie direkt zum Kontaktieren einer Buchsenleiste nutzbar sind. Diese Ausführungsform eignet sich insbesondere für die SMD-Anschlußtechnik.

Vorzugsweise sind die Signalwege der Busleiterabschnitte benachbarter Module derart versetzt miteinander verbunden, daß in Abhängigkeit von der Anzahl der versetzten Datenleitungen auf einfache Weise erkennbar ist, ob eine oder mehrere vor einem Teilnehmer vorgesehene Leiterplatten auf dem Basis-Klemmenträger vorhanden ist oder nicht.

Weitere vorteilhafte Ausführungsformen der Neuerung sind den übrigen Unteransprüchen zu entnehmen. Nachfolgend wird die Neuerung unter Bezug auf die Zeichnung anhand von Ausführungsbeispielen näher beschrieben. Es zeigt:
Fig. 1 eine Sprengansicht einer Modulscheibe eines elektrischen Gerätes mit einem internen Busleiterabschnitt gemäß der Neuerung;
Fig. 2 und 3a-d verschiedene perspektivische Ansichten des Busleiterabschnittes aus Fig. 1;
Fig. 4 eine Darstellung zweier aneinander gesetzter Busleiterabschnitte;
Fig. 5a und b sowie 6 und 7 verschiedene Ansichten von an einen Gerätestecker einer Elektronik-Leiterplatte angesetzten Busleiterabschnitten;
Fig. 8 eine Sprengansicht wesentlicher Elemente eines internen Busleiterabschnittes gemäß der Neuerung;
Fig. 9 eine Darstellung des Prinzips der Verbindung zwischen den Eingängen und den Ausgängen des Busleiterabschnittes.

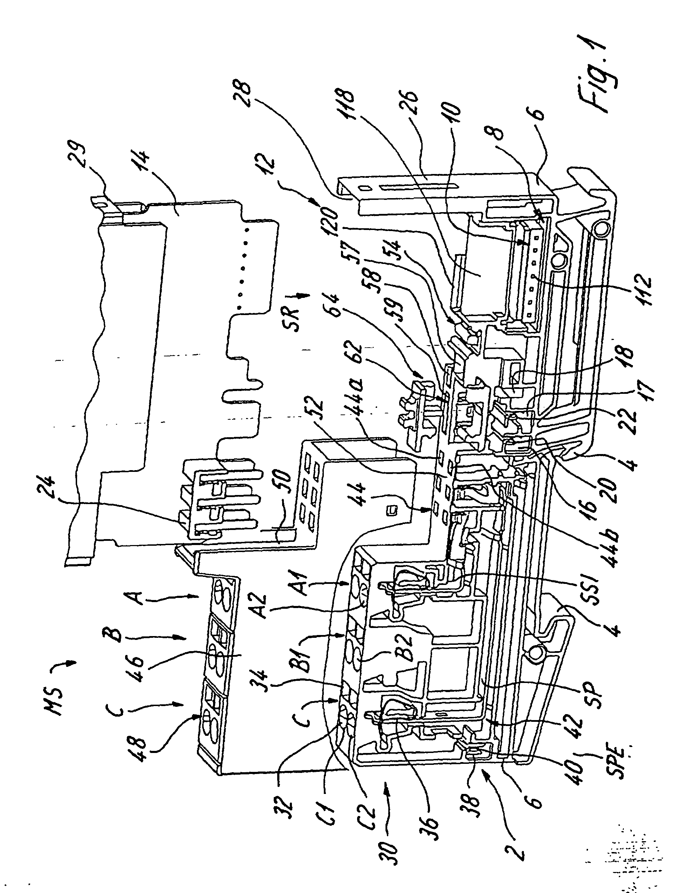

Fig. 1 zeigt eine Modulscheibe MS für ein hier ansonsten nicht dargestelltes Gerät der Automatisierungstechnik. Das Gerät umfaßt ein Gateway (hier nicht dargestellt), an welches u.a. die Modulscheiben MS anreihbar sind. Die Modulscheibe MS ist mit weiteren Modulscheiben MS zu einem Anschlußblock variabler Länge zusammenfügbar.

Die Modulscheibe MS weist nach Fig. 1 einen scheibenförmigen Basis-Klemmenträger 2 zur Verriegelung des Einzelmodules auf einer (hier nicht dargestellten) Tragschiene auf. Der Basis-Klemmenträger 2 ist hierzu mit Kunststoff-Rastfüßen 4 versehen, mit denen in an sich bekannter Weise die Rastverbindung zur Tragschiene herstellbar ist. Der Basis-Klemmenträger 2 umfaßt einen unteren Basisabschnitt 6, welcher sich in einen Bereich oberhalb der Tragschienenfüße 4 und neben den Tragschienenfüßen 4 beidseitig über die Tragschiene hinaus erstreckt. In dem Basisabschnitt 6 ist in dem einen von der Tragschiene abgewandt liegenden Außenbereich eine den Basis-Klemmenträger 2 senkrecht zu seiner Haupt-Erstreckungsebene durchdringende Ausnehmung 8 zur Aufnahme des internen Busleiterabschnitts 10 vorgesehen, der eine Weiterleitung der Busleitersignale von Einzelmodul zu Einzelmodul und in die Elektronik-Leiterplatte 14 erlaubt.

Zur Aufnahme der Elektronik-Leiterplatte 14 ist in dem Bereich, welcher sich ungefähr von der Senkrechten zur Mitte der Tragschiene bis zu dem internen Busleiterabschnitt 10 erstreckt, in dem Basis-Klemmenträger 2 eine Umfangs-Ausnehmung 12 ausgebildet. Die Elektronik-Leiterplatte 14 ist mit einer (hier nicht dargestellten) Elektronikschaltung zur Verarbeitung/Weiterleitung der jeweils zur Elektronik-Leiterplatte 14 geführten Signale versehen.

In dem zwischen dem internen Busleiterabschnitt 10 und dem Rastfuß 4 liegenden Bereich ist der Basisabschnitt 6 mit drei weiteren, nebeneinander liegenden Öffnungen 16, 17, 18 versehen, die jeweils senkrecht zur Hauptscheiben- bzw. -modulebene den Basis-Klemmenträger 2 durchdringen und von denen zwei Öffnungen 16, 17 mit als Querbrückern ausgelegten Kontaktelementen 20, 22 versehen sind, welche eine Weitergabe der zugeordneten Potentials von Modul zu Modul ermöglichen. Die weitere Öffnung 18 dient - wie weitere der hier nicht beschriebenen Öffnungen im Basis-Klemmenträger - lediglich der Materialersparnis. Von den Querbrückern 20, 22 werden diese Potentiale in die Leiterplatte und/oder über einen geeigneten separaten oder an die Elektronik-Leiterplatte angeformten Stecker 24 zu den Anschlüssen zu den Stromschienen im Basis-Klemmenträger 2 und über diese zu den Anschlußebenen A, B, C der Modulscheibe MS geführt.

Die Ausnehmung 12 wird an dem von der Tragschiene abgewandten Ende des Einzelmodules von einem senkrecht vom Basisabschnitt abstehenden Steg 26 begrenzt, der an seiner zur Tragschiene 4 gewandten Seite mit einer Einschubnut 28 zum Einschieben der Elektronik-Leiterplatte 14 sowie eines Elektronikgehäuses 29 versehen ist.

Ungefähr an dem dem Steg 26 gegenüberliegenden Ende des Basis-Klemmenträgers 2 ist an den Basisabschnitt 6 ein senkrecht nach oben vorstehender Anschlußabschnitt 30 angeformt, der mit den sechs in zwei Reihen zu je drei angeordneten Anschlüssen A1, A2, ... versehen ist. Öffnungen 34 mit quadratischem Querschnitt neben Anschlußöffnungen 32 für die Anschlüsse A1, A2, B1, B2 ... erlauben das Einführen eines Schraubendrehers zum Öffnen der im Anschlußabschnitt 30 angeordneten Feder-Kontaktelemente 36.

Außerhalb der dritten Anschlußebene C ist im Basisabschnitt eine weitere senkrecht zur Modulscheibenebene liegende, den Basis-Klemmenträger 2 -durchdringende Öffnung 38 vorgesehen, in welcher ein weiteres Kontaktelement 40 liegt, über das der Schutzleiter PE von Einzelmodul zu Einzelmodul weitergegeben wird.

Die leitende Verbindung zwischen den Kontaktfedern 36 der Anschlüsse A, B, C, ... und der Elektronik-Leiterplatte 14 wird mittels Stromschienen (hier dargestellt: SP für das Pluspotential und SSI für das Signal, nicht zu erkennen: SM für das negative Potential) realisiert. Die Stromschienen SM, SP verlaufen von den Kontaktfedern 36 in seitlichen Nuten/Ausnehmungen 42 des Grundelementes 2 im wesentlichen u-förmig an beiden Hauptaussenflächen des Basis-Klemmenträgers 2. Unterhalb der Aussparung 12 für die Elektronik-Leiterplatte sind die Stromschienen nach oben hin abgewinkelt und verlaufen zur Umfangs-Ausnehmung 12, welche in diesem Bereich mit sechs in zwei Reihen nebeneinander liegenden Anschlußöffnungen 44 zum Aufsetzen des Gerätesteckers 24 an der Elektronik-Leiterplatte und/oder des Leiterplattenrandes versehen ist.

Über den Anschlußabschnitt 30 ist ein Abdeckgehäuse 46 aus Kunststoff aufsetzbar, welches Öffnungen 48 aufweist, die mit den Anschlußöffnungen 32 und den Öffnungen 34 korrespondieren. Zum: Bereich der Aussparung 12 des Basis-Klemmenträgers 2 hin ist die Abdeckung ferner mit einer seitlichen Nut 50 versehen, welche im Zusammenwirken mit der Nut 28 die Elektronik-Leiterplatte 14 und das die Elektronik-Leiterplatte 14 schützende Gehäuse 29 aufnimmt, welches in Steckrichtung SR auf den Basis-Klemmenträger 2 aufsetzbar ist.

Der Basis-Klemmenträger 2 bzw. die Modulscheibe MS umfaßt im Bereich der Aussparung 12 an/unterhalb der Grundwandung 52 der Aussparung 12 (von dem Steg 26 aus gesehen nach innen zur Tragschiene hin) folgende Funktionsbereiche:
- Modulbus(öffnung) BUS / 8
- Kennzeichnungskanal (für ein oder zwei Schilder) 54
- seitlicher Rasthaken als Verbindung zur Nachbarklemme mit Öffnung 57 zur Betätigung des Rasthakens von oben 57
- FE-Kontakt (Funktionserde) 58
- Potentialführungs-Kontaktierungsöffnung 59
- Steckerbuchsen/Anschlußöffnungen 44.

Neben dem FE-Kontakt 58 und den Öffnungen 44 zu den Potentialführungen PE+, PEist in besonders raumsparender Weise eine Ausnehmung 62 für ein Kodierelement 64 vorgesehen.

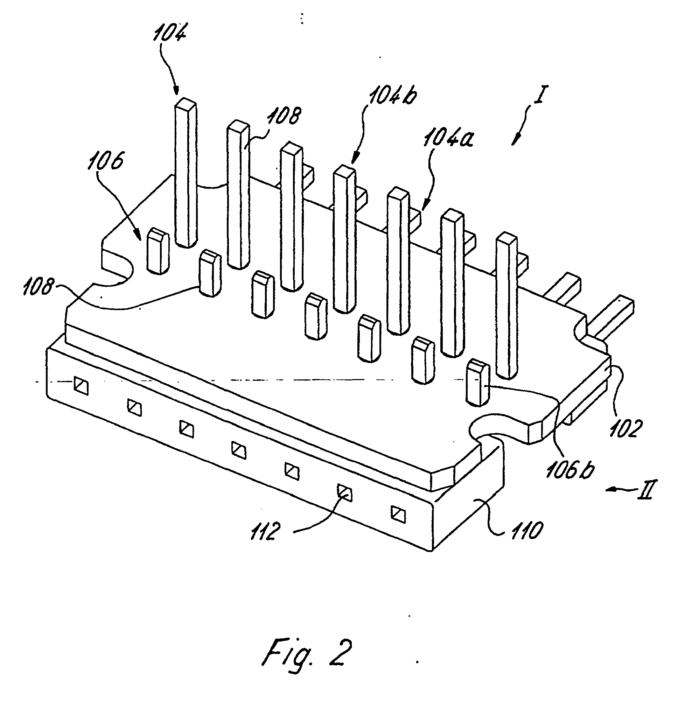

Der in die Öffnung 8 eingesetzte interne Busleiterabschnitt 10 jedes Basis-Klemmenträgers 2 weist nach Fig. 2 jeweils eine Platine 102 auf, die von einer Reihe 104 Metallstifte 108 durchsetzt ist, welche auf der einen Seite der Platine 102 (Seite I) im wesentlichen senkrecht und auf der gegenüberliegenden Seite der Platine 102 (Seite II) im wesentlichen parallel zur Platine 102 ausgerichtet sind. Eine zweite Reihe 106 von Metallstiften 108 durchdringt zwar ebenfalls gerade eben die Leiterplatte, aber nur mit kurzen Lötenden 106b. Das andere Ende 104a dieser Stiftreihe 106 liegt mit den Stiftreihenenden 104a in einer Ebene, die Enden der Stiftreihen 104, 106 sind in der Ebene voneinander abgewandt. Die Stiftreihenenden 104a der einen Reihe 104 der Metallstifte 108 steht seitlich über den Rand der Platine 102 vor.

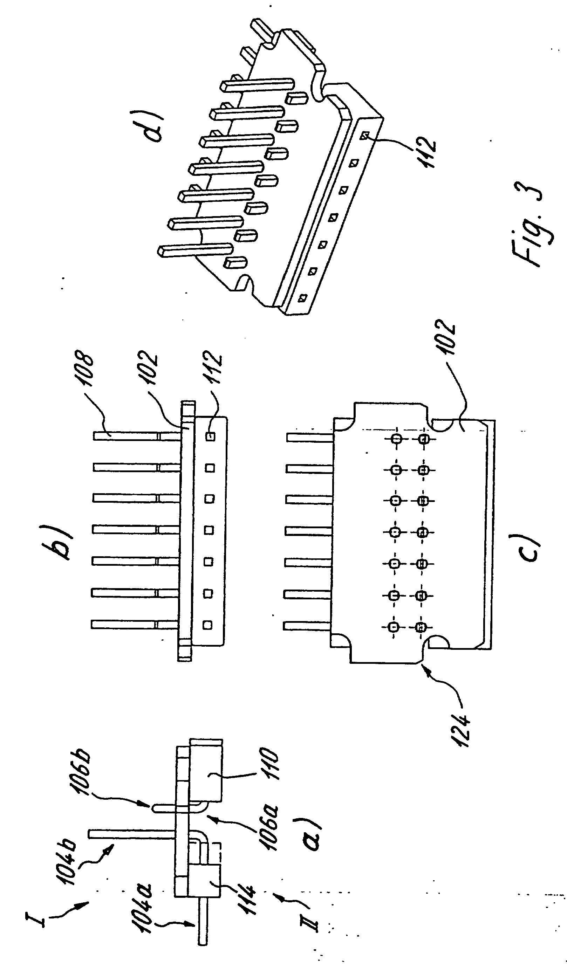

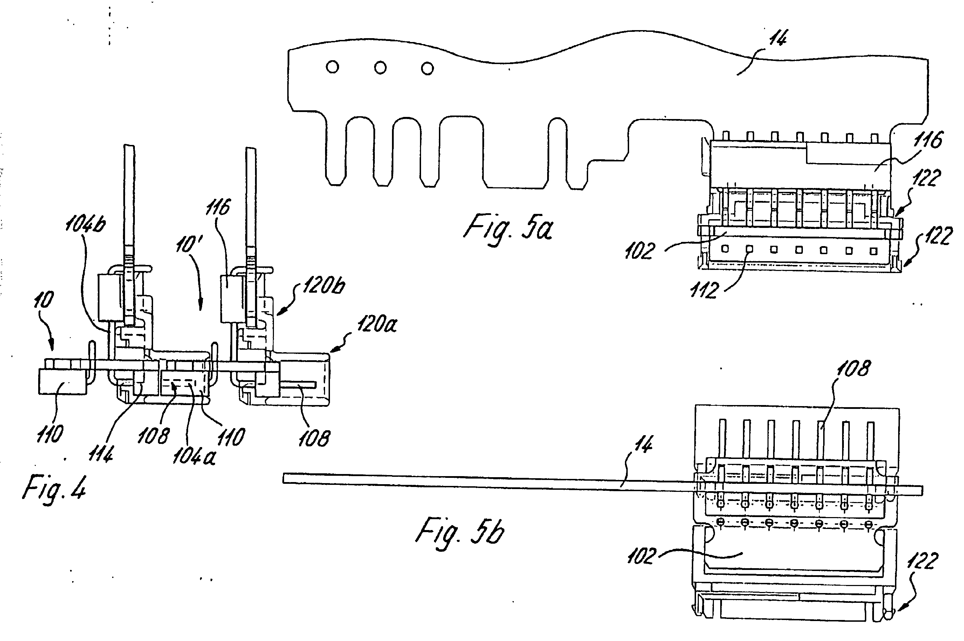

Wie in Fig. 2 und 3 dargestellt, ist auf die Stiftreihenenden 106a der einen der beiden parallel zur Platine verlaufenden Reihen 106 von Metallstiften 108 eine alle Stiftreihenenden 106a dieser Reihe 106 übergreifende Steckerbuchsenleiste 110 mit Steckerbuchsen(öffnungen) 112 und auf die entsprechenden Stiftreihenenden 104a der anderen Stiftreihe 104 eine Steckerstift-Gehäuseleiste 114 aufgesetzt. Wie ferner in Fig. 4 zu erkennen, greifen bei nebeneinanderliegenden bzw. aneinandergreihten Basis-Klemmenträgern die Steckerstift-Reihenenden 104a jedes Busleiterabschnitts jeweils in die Steckerbuchsen 112 des Busleiterabschnitts 10' des jeweils benachbarten Basis-Klemmenträgers 2 ein.

Da eine der senkrecht zur Platine stehenden Stiftreihen 104 derart lang ausgebildet ist, daß ihre Stiftreihenenden direkt zum Kontaktieren einer direkt an der Elektronik-Leiterplatte 14 angeformter Buchsenleiste 116 zur Elektronik-Leiterplatte 14 genutzt werden können, entfällt die Notwendigkeit zur Ausbildung eines separaten Steckerelementes für diesen Zweck an der Platine 102 des Busleiterabschnitts 10. Diese Funktion übernehmen vielmehr die Winkelstifte 108 mit.

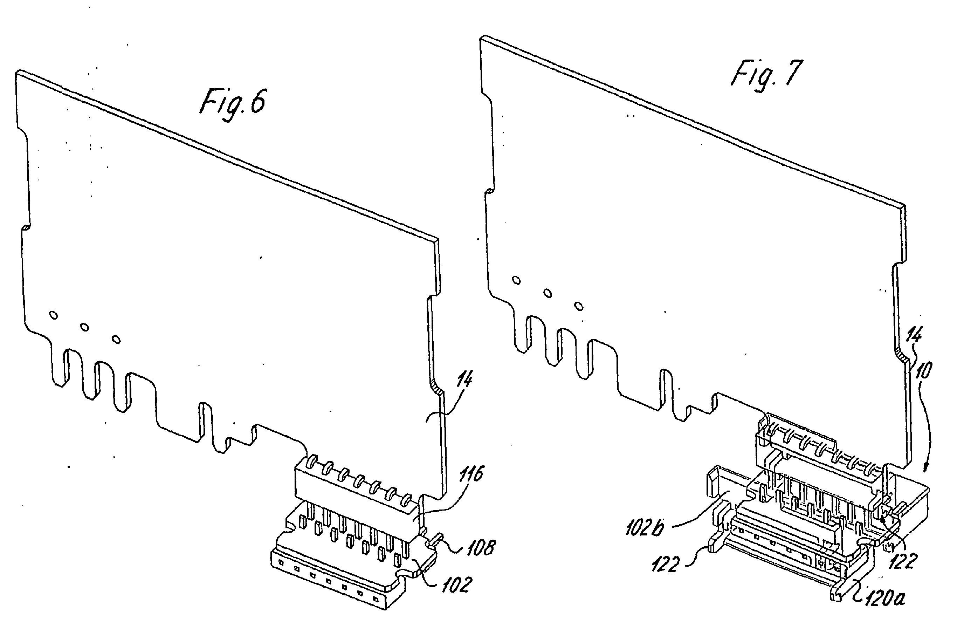

Fig. 4 und 5 veranschaulichen im Zusammenspiel mit Fig. 1 und Fig. 7 die vorteilhafte Lage der Busleiterabschnitte 10 im Basis-Klemmenträger 2. Die Busleiterabschnitte 10 werden in die Öffnung 8 eingeschoben, wo die Stiftreihe 104 gegen eine vom Basis-Klemmenträger 2 senkrecht nach oben vorstehende Wandung 118 zum Schutz der Stifte und des entsprechenden Bereiches der Elektronik-Leiterplatte 14 anliegt. Nach dem Einschieben des Busleiterabschnittes 10 wird ein Kunststofformteil 120 mit der Funktion einer Schutz- und Abdeckplatte ebenfalls in die Öffnung 8 eingeschoben, wo es mit Rastfüssen 122 im Basis-Klemmenträger 2 verrastet. Der in Fig. 4 obere, d.h. zur Elektronikleiterplatte liegende Bereich 120b des Kunststofformteiles legt die Stiftreihe 104 an der Wandung 118 fest, der untere Teil 120a dient als über den Rand des Klemmenträgers 2 vorstehende Schutzabdeckung für die Stiftreihenenden 104a und zum Eingriff in die Öffnung 8 eines benachbarten Basis-Klemmenträgers 2.

Da die Busleiterabschnitte 10 in die Busleiteröffnung 8 des Basis-Klemmenträgers seitlich, vorzugsweise aus Richtung eines Gateways, des Basis-Klemmenträgers 2 einschiebbar sind und da die Platine 102 mit einer Anschlagkante 124 zum Anschlag an einer Gegenkante des Basis-Klemmenträgers 2 versehen ist, ergibt sich der besondere Vorteil, daß der Busleiterabschnitt 10 sowohl beim Einschieben oder Ziehen der Elektronik - als auch beim Entriegeln des Basis-Klemmenträgers 2 vom benachbarten Basis-Klemmenträger 2 am Rasthaken - im Basis-Klemmenträger 2 sicher fixiert ist.

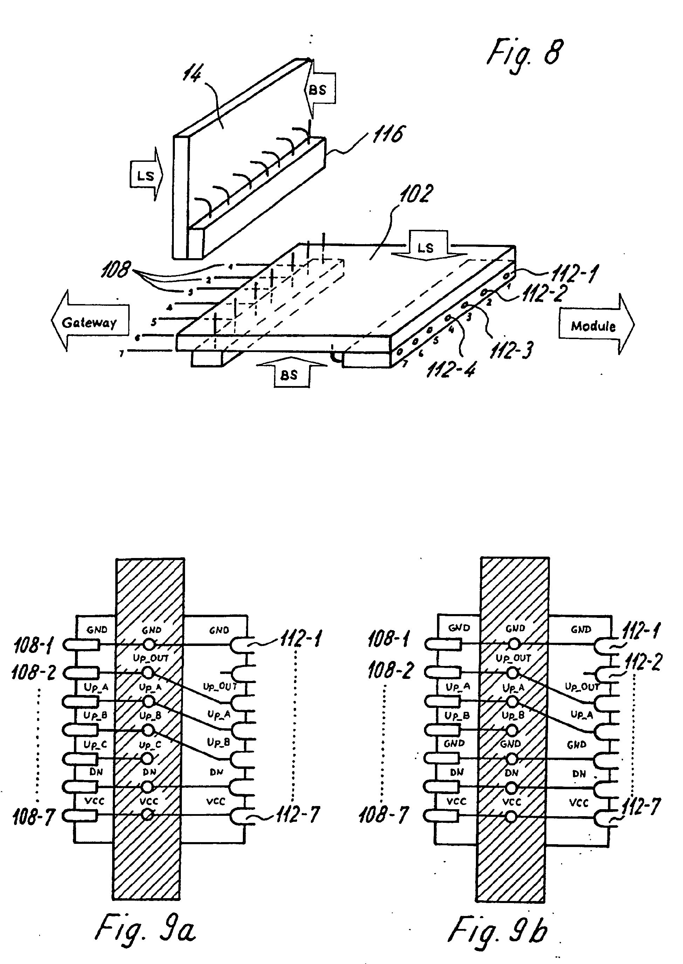

Fig. 8 veranschaulicht die Einbindung des internen Busleiterabschnitts 10 in das übergreifende Modulsystem. An einem Gateway ist der Anschluß eines externen Feldbusses möglich. Sowohl die Energieversorgung des Gateways und der Anschlußmodule bzw. der Modulscheiben MS als auch die Weiterleitung des Datenbusses vom Gateway zu den Elektronik-Leiterplatten 14 der einzelnen Basis-Klemmenträger 2 bzw. der Modulscheiben MS und Modulblöcke erfolgt sowohl in einem Block- als auch in einem Scheibenautbau mittels der dargestellten internen Busleiterabschnitte 10. Dabei sind die beiden Steckerstiftreihen 108 über die Platine 102 miteinander derart verbunden, daß diese Verbindungen Potential- und Signalwege von Busleiterabschnitt 10 zu Busleiterabschnitt als auch Potential- und Signalwege vom Busleiterabschnitt 10 zu den Elektronik-Leiterplatten 14 des Basis-Klemmenträger 2 bilden.

Hinsichtlich der Verbindung der Datenleitungen von Busleiterabschnitt 10 zu Busleiterabschnitt 10 nach Fig. 9 bleibt anzumerken, daß die Verbindung zwischen der Eingangs- und der Ausgangsseite jedes Busleiterabschnittes 10 derart erfolgt, daß wenigstens einige der Datenleitungen nach Art der Fig. 9 versetzt miteinander verbunden sind (Hin: Ringstruktur bzw. versetzte Leitungen, Rück: Linienstruktur an der durchgehend gereihten und nicht versetzt angeordneten Leitung DN, siehe Steckerstift 108-6; Buchse 112-6, Fig. 9b). So wird nach Fig. 9b der "Eingangs"-Stift 108-2 mit der "Ausgangs"-Buchse 112-3, der Stift 108-3 mit der Ausgangsbuchse 112-4 und der Stift 108-4 mit der Elektronik-Leiterplatte 14 ("Teilnehmer") verbunden. Auf diese Weise sind die Signalwege der Busleiterabschnitte benachbarter Module derart miteinander verbunden, daß in Abhängigkeit von der Anzahl der versetzten Datenleitungen in Hin-Richtung erkennbar ist, ob vor dem Teilnehmer eine Elektronik-Leiterplatte 14 von dem Basis-Klemmenträger 2 abgenommen wurde.

Mit einer weiteren versetzten Datenleitung in Hinrichtung entsprechend zu Fig. 9a sind sogar vor der aufgesteckten Elektronik-Leiterplatte 14 des Teilnehmers (N) jeweils zwei abgenommene Elektronik-Leiterplatten bzw. zwei Teilnehmbar (N-1 oder N-2 oder N-1 und N-2 gemeinsam) erkennbar. Die Varianten der Fig. 9a und 9b sind untereinander nicht kombinierbar.

### Bezugszeichen

- Modulscheibe: MS
- Anschlußebenen: A, B, C, ...
- Mehrfachanschlüsse: A1, A2, ..., B1, B2, ...
- Schutzerde: PE
- Funktionserde: FE
- Stromzuführschienen: SP, SSI, SPE
- Steckrichtung: SR
- Basis-Klemmenträger: 2
- Kunststoff-Rastfüße: 4
- Basisabschnitt: 6
- Busleiteröffnung: 8
- Busleiterabschnitt: 10
- Umfangs-Ausnehmung: 12
- Elektronik-Leiterplatte: 14
- Öffnungen: 16,17,18
- Kontaktelemente: 20, 22
- Stecker: 24
- Steg: 26
- Einschubnut: 28
- Elektronikgehäuse: 29
- Anschlußabschnitt: 30
- Runde Öffnungen: 32
- Quadratische Öffnungen: 34
- Feder-Kontaktelemente: 36
- Öffnung: 38
- Kontaktelement: 40
- Aussparungen: 42
- Anschlußöffnungen: 44
- Abdeckgehäuse: 46
- Öffnungen: 48
- Nut: 50
- Grundwandung: 52
- Kennzeichnungskanal: 54
- Öffnung: 57
- FE-Kontakt: 58
- Potential-Kontaktierungsöffnung: 59
- Ausnehmung: 62
- Kodierlelement: 64
- Platine: 102
- Stiftreihen: 104, 106
- Metallstifte: 108
- Steckerbuchsenleiste: 110
- Steckerbuchsenöffnungen: 112
- Steckerstift-Gehäuseleiste: 114
- Buchsenleiste: 116
- Wandung: 118
- Kunststofformteil: 120
- Rastfuß: 122
- Anschlagkante: 124

## Patentansprüche

1. Busleiterabschnitt für ein elektrisches Gerät mit modularem Aufbau zur Steuerung und/oder Überwachung technischer Prozesse und/oder zur Industrie- und/oder Gebäudeautomatisierung,
a) mit wenigstens einem auf eine Tragschiene aufsetzbaren Anschlußmodul (M) mit Anschlüssen (A1, A2, B1, ...) für externe Leiter und mit einer Reihung scheibenförmiger Basis-Klemmenträger (2),
b) wobei innerhalb jedes Anschlußmodules (M) der interne Busleiterabschnitt (10) im wesentlichen parallel zur Tragschiene verläuft,
**dadurch gekennzeichnet**,
c) daß die Busleiterabschnitte (10) der einzelnen Basis-Klemmenträger (2) baulich voneinander getrennt ausgebildet sind und jeweils eine Platine (102) aufweisen, die von wenigstens einer Reihe (104) von Metallstiften (108) durchsetzt ist, welche auf der einen Seite der Platine (102) im wesentlichen senkrecht und auf der gegenüberliegenden Seite der Platine (102) im wesentlichen parallel zur Platine (102) ausgerichtet sind,
d) wobei die wenigstens eine senkrecht zur Platine erstreckende Stiftreihe (104) derart bemessen ist, daß ihre Stiftreihenenden (104b) direkt zum Kontaktieren einer Buchsenleiste (116) nutzbar sind.

2. Busleiterabschnitt nach dem Oberbegriff des Anspruches 1, **dadurch gekennzeichnet, daß**
- die Busleiterabschnitte (10) der einzelnen Basis-Klemmenträger (2) baulich voneinander getrennt ausgebildet sind und jeweils eine Platine (102) aufweisen, auf die wenigstens eine Reihe (104) abgewinkelter Metallstifte (108) aufgesetzt ist, welche mit ihren einen Enden im wesentlichen senkrecht und mit ihren anderen Enden im wesentlichen parallel zur Platine (102) ausgerichtet sind,
- wobei die senkrecht zur Platine stehenden Stiftreihenenden (104b) derart bemessen sind, daß sie direkt zum Kontaktieren einer Buchsenleiste (116) nutzbar sind.

3. Busleiterabschnitt nach einem der vorstehenden Ansprüche, **dadurch gekennzeichnet, daß** die Stiftreihenenden (104a) der einen Reihe (104) der Metallstifte (108) seitlich über den Rand der Platine (102) vorstehen.

4. Busleiterabschnitt nach einem der vorstehenden Ansprüche, **dadurch gekennzeichnet, daß** auf Stiftreihenenden (106a) einer parallel zur Platine verlaufenden Reihe (106) von Metallstiften (108) eine Steckerbuchsenleiste (110) und auf die Stiftreihenenden (104a) der anderen parallel zur Platine verlaufenden Reihe (104) von Metallstiften (108) eine Steckerstiftgehäuse-Leiste (114) aufgesetzt ist, wobei bei nebeneinanderliegenden Basis-Klemmenträgem (2) die Enden (104a) der einen Reihe (104) der Metallstifte (108) in die Steckerbuchsenleiste (110) des Busleiterabschnittes (10') des jeweils benachbarten Basis-Klemmenträgers (2) eingreifen.

5. Busleiterabschnitt nach einem der vorstehenden Ansprüche, **dadurch gekennzeichnet, daß** die beiden Stiftreihen (104, 106) über die Platine (102) miteinander verbunden sind, so daß Potential- und Signalwege von Busleiterabschnitt (10) zu Busleiterabschnitt (10') als auch vom Busleiterabschnitt (10) zu den Elektronik-Leiterplatten (14) der Basis-Klemmenträger (2) gebildet werden.

6. Busleiterabschnitt nach einem der vorstehenden Ansprüche, **dadurch gekennzeichnet, daß** ein Teil der Signalwege der Busleiterabschnitte (10) benachbarter Module derart versetzt miteinander verbunden ist, daß in Abhängigkeit von der Anzahl der versetzten Datenleitungen erkennbar ist, ob eine oder mehrere vor einem Teilnehmer vorgesehene Leiterplatten (14) auf dem Basis-Klemmenträger (2) vorhanden ist oder nicht.

7. Busleiterabschnitt nach einem der vorstehenden Ansprüche, **dadurch gekennzeichnet, daß** die Busleiterabschnitte (10) in der Öffnung (8) des Basis-Klemmenträgers zwischen einer Wandung (118) des Basis-Klemmenträgers (2) und einem in die Öffnung (8) einschiebbaren Kunststofformteil (120) mit der Funktion einer Schutz- und Abdeckplatte festgelegt sind.

8. Busleiterabschnitt nach einem der vorstehenden Ansprüche, **dadurch gekennzeichnet, daß** die Busleiterabschnitte (10) in die Busleiteröffnung (8) des Basis-Klemmenträgers (2) seitlich, vorzugsweise aus Richtung eines Gateways einschiebbar sind.

9. Busleiterabschnitt nach einem der vorstehenden Ansprüche, **dadurch gekennzeichnet, daß** die Platine mit einer Anschlagkante (124) zum Anschlag an einer Gegenkante des Basis-Klemmenträgers (2) versehen ist.

## Revendications

1. Tronçon de bus pour un appareil électrique de construction modulaire pour commander et/ou surveiller des processus techniques et/ou pour une automatisation industrielle et/ou de bâtiment,
a) avec au moins un module de branchement (M) pouvant être monté sur un rail porteur avec des branchements (A 1, A2, B1, ...) pour des conducteurs extérieurs et avec une série de supports de borne de base (2) en forme de disque,
b) le tronçon de bus interne (10) s'étendant pour l'essentiel parallèlement au rail porteur à l'intérieur de chaque module de branchement (M),
**caractérisé en ce que**
c) les tronçons de bus (10) des différents supports de borne de base (2) sont construits séparément les uns des autres et présentent chacun une platine (102) qui est traversée par au moins une rangée (104) d'ergots métalliques (108) qui sont orientés pour l'essentiel perpendiculairement à la platine (102) d'un côté de la platine (102) et pour l'essentiel parallèlement à elle du côté opposé de la platine (102),
d) la rangée d'ergots (104) au nombre d'au moins une s'étendant perpendiculairement à la platine ayant des dimensions telles que ses extrémités de rangée d'ergots (104) sont utilisables directement pour mettre en contact une barrette de douilles (116).

2. Tronçon de bus selon le préambule de la revendication 1, **caractérisé en ce que**
- les tronçons de bus (10) des divers supports de borne de base (2) sont construits séparément les uns des autres et présentent chacun une platine (102) sur laquelle est rapportée au moins une rangée (104) d'ergots métalliques coudés (108) qui sont orientés avec leurs premières extrémités pour l'essentiel perpendiculairement à la platine (102) et avec leurs autres extrémités pour l'essentiel parallèlement à elle,
- les extrémités de rangée d'ergots (104b) perpendiculaires à la platine ayant des dimensions telles qu'elles sont utilisables directement pour mettre en contact une barrette de douilles (116).

3. Tronçon de bus selon l'une des revendications précédentes, **caractérisé en ce que** les extrémités (104a) de la première rangée (104) d'ergots métalliques (108) dépassent latéralement du bord de la platine (102).

4. Tronçon de bus selon l'une des revendications précédentes, **caractérisé en ce que** sur des extrémités (106a) d'une rangée (106) d'ergots métalliques (108) parallèle à la platine est rapportée une barrette de fiches femelles (110) et sur les extrémités de l'autre rangée (104) d'ergots métalliques (108) parallèle à la platine est rapportée une barrette (114) de boîtiers de fiches mâles, les extrémités (104a) de la première rangée (104) d'ergots métalliques (108) s'engageant dans la barrette de fiches femelles (110) du tronçon de bus (10') du support de borne de base (2) respectivement voisin quand les supports de bornes de base (2) sont juxtaposés.

5. Tronçon de bus selon l'une des revendications précédentes, **caractérisé en ce que** les deux rangées d'ergots (104, 106) sont reliées par l'intermédiaire de la platine (102), de sorte que des voies de potentiel et de signaux sont formées du tronçon de bus (10) vers le tronçon de bus (10') ainsi que du tronçon de bus (10) vers les circuits imprimés électroniques (14) du support de borne de base (2).

6. Tronçon de bus selon l'une des revendications précédentes, **caractérisé en ce qu'**une partie des voies de signal des tronçons de bus (10) de modules voisins sont reliés entre eux avec un décalage, de sorte qu'en fonction du nombre de lignes de données posées, on peut déterminer si un ou plusieurs circuits imprimés (14) prévu par un participant est présent ou non sur le support de borne de base (2).

7. Tronçon de bus selon l'une des revendications précédentes, **caractérisé en ce que** les tronçons de bus (10) sont fixés dans l'ouverture (8) du support de borne de base entre une paroi (118) du support de borne de base (2) et une pièce moulée en plastique (120) insérable dans l'ouverture (8) et servant de plaque de protection et de fermeture.

8. Tronçon de bus selon l'une des revendications précédentes, **caractérisé en ce que** les tronçons de bus (10) peuvent être insérés dans l'ouverture de bus (8) du support de borne de base (2) latéralement, de préférence depuis la direction d'une passerelle.

9. Tronçon de bus selon l'une des revendications précédentes, **caractérisé en ce que** la platine est munie d'un bord de butée (124) destiné à buter contre un bord opposé du support de bornes de base (2).

## Claims

1. Bus conductor portion of modular construction for an electrical device for controlling and/or monitoring technical processes and/or for industrial and/or building automation,
a) with at least one terminal module (M) which can be placed on a support rail, incorporating terminals (A1, A2, B1, ...) for external conductors and with a series of disc-shaped base terminal supports (2),
b) in which the internal bus conductor portion (10) extends essentially parallel with the support rail inside every terminal module (M),
**characterised in that**
c) the bus conductor portions (10) of the individual base terminal supports (2) are designed to be structurally separate from one another, each with a circuit board (102) which has at least one row (104) of metal pins (108) extending through it which are oriented essentially vertically on one side of the circuit board (102) and essentially parallel with the circuit board (102) on the oppositely lying side of the circuit board (102),
d) and the at least one pin row (104) extending vertically with respect to the circuit board is dimensioned so that its pin row ends (104b) can be used to establish direct contact with a bus bar (116).

2. Bus conductor portion as claimed in the introductory part of claim 1, **characterised in that**
- the bus conductor portions (10) of the individual base terminal supports (2) are structurally separate from one another, each with a circuit board (102) on which is placed the at least one row (104) of angled metal pins (108), which are oriented essentially vertically at their one free end and essentially parallel at their other end with respect to the circuit board (102),
- and the pin row ends (104b) extending vertically with respect to the circuit board are dimensioned so that they can be used to establish direct contact with a bus bar (116).

3. Bus conductor portion as claimed in one of the preceding claims, **characterised in that** the pin row ends (104a) of a row (104) of metal pins (108) project sideways beyond the edge of the circuit board (102).

4. Buys conductor portion as claimed in one of the preceding claims, **characterised in that** a female connector strip (110) is placed on pin row ends (106a) of a row (106) of metal pins (108) extending parallel with the circuit board and a male connector housing strip (114) is placed on the pin row ends (104a) of the other row (104) of metal pins (108) extending parallel with the circuit board, and the ends (104a) of one row (104) of metal pins (108) of adjacently lying base terminal supports (2) engage in the female connector strip (110) of the bus conductor portion (10') of the respective adjacent base terminal support (2).

5. Bus conductor portion as claimed in one of the preceding claims, **characterised in that** the two pin rows (104, 106) are connected to one another via the circuit board (102) so that potential and signal paths are established from bus conductor portion (10) to bus conductor portion (10') as well as from the bus conductor portion (10) to the electronic system-circuit boards (14) of the base terminal supports (2).

6. Bus conductor portion as claimed in one of the preceding claims, **characterised in that** a part of the signal paths of the bus conductor portions (10) of adjacent modules are connected to one another in an offset arrangement so that, depending on the number of offset data lines, it can be detected whether one or more circuit boards (14) on the base terminal support (2) upstream of a subscriber is available or not.

7. Bus conductor portion as claimed in one of the preceding claims, **characterised in that** the bus conductor portions (10) are secured in the orifice (8) of the base terminal support between a wall (118) of the base terminal support (2) and a plastic moulded part (120) which can be inserted in the orifice (8) and fulfils the function of a protective cover plate.

8. Bus conductor portion as claimed in one of the preceding claims, **characterised in that** the bus conductor portions (10) can be inserted in the bus conductor orifice (8) of the base terminal support (2) from the side, preferably from the direction of a gateway.

9. Bus conductor portion as claimed in one of the preceding claims, **characterised in that** the circuit board is provided with an abutment edge (124) which sits in abutment with a complementary edge of the base terminal support (2).
